(19) Europäisches Patentamt
European Patent Office
Office européen des brevets

(11) **EP 2 560 187 B1**

(12) **FASCICULE DE BREVET EUROPEEN**

(45) Date de publication et mention
de la délivrance du brevet:
**15.11.2017   Bulletin 2017/46**

(51) Int Cl.:
*H01J 37/317* *(2006.01)*      *H01J 37/22* *(2006.01)*

(21) Numéro de dépôt: **12179945.6**

(22) Date de dépôt: **09.08.2012**

(54) **Procédé de correction des effets de proximité électronique utilisant des fonctions de diffusion decentrees**

Verfahren zur Korrektur des elektronischen Proximity-Effekts durch Verwendung nicht-zentrierter Diffusionsfunktionen

Method for correcting electronic proximity effects using off-centre scattering functions

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **16.08.2011   FR 1157338**

(43) Date de publication de la demande:
**20.02.2013   Bulletin 2013/08**

(73) Titulaires:
• **COMMISSARIAT À L'ÉNERGIE ATOMIQUE ET AUX
ÉNERGIES ALTERNATIVES**
**75015 Paris (FR)**
• **Aselta Nanographics**
**38000 Grenoble (FR)**

(72) Inventeurs:
• **Schiavone, Patrick**
**38190 Villard-Bonnot (FR)**
• **Figueiro, Thiago**
**38000 Grenoble (FR)**

(74) Mandataire: **Nguyen Van Yen, Christian
Marks & Clerk France
Conseils en Propriété Industrielle
Immeuble Visium
22, Avenue Aristide Briand
94117 Arcueil Cedex (FR)**

(56) Documents cités:
**US-A1- 2008 067 446**

• **ANDERSON ERIK H ET AL: "Influence of sub-100 nm scattering on high-energy electron beam lithography*", JOURNAL OF VACUUM SCIENCE AND TECHNOLOGY: PART B, AVS / AIP, MELVILLE, NEW YORK, NY, US, vol. 19, no. 6, 1 novembre 2001 (2001-11-01), pages 2504-2507, XP012009072, ISSN: 1071-1023, DOI: 10.1116/1.1415506**

**Description**

La présente invention s'applique notamment au domaine de la lithographie électronique pour la gravure directe sur wafer ou pour la fabrication de masques. Plus généralement, elle s'applique à tout domaine où on a besoin de modéliser l'interaction d'un faisceau d'électrons avec une cible, ce qui est également le cas en microscopie électronique, notamment pour l'inspection des wafers et des masques. Cette interaction est notamment affectée par une diffusion des électrons autour de la trajectoire initiale (effet de forward scattering ou de diffusion vers l'avant) ainsi que par une rétrodiffusion (effet de back scattering ou de diffusion vers l'arrière). Ces effets, qualifiés d'effets de proximité, dépendent notamment des matériaux de la cible et de sa géométrie. Quelle que soit la raison pour laquelle on souhaite effectuer ce bombardement électronique (gravure, imagerie ou analyse), il est donc nécessaire de tenir compte des effets de proximité pour obtenir un résultat qui soit fidèle à l'objectif recherché. On effectue donc une correction des effets de proximité. Pour cela, il est connu de les prédire par un modèle pour en tenir compte dans le calcul des doses de rayonnement électronique utilisées pour bombarder la cible. Il est connu pour cela d'utiliser une fonction dite de diffusion ou d'étalement de point (ou PSF, point spread function) et l'on réalise une convolution de la PSF avec la géométrie de la cible. Une PSF utilisée communément est une combinaison de gaussiennes, une première gaussienne pour modéliser la diffusion vers l'avant (PSF de la diffusion vers l'avant), et une ou plusieurs gaussiennes supplémentaires pour modéliser la rétrodiffusion (PSF de la rétrodiffusion).

L'équation de la PSF est ainsi traditionnellement représentée par une fonction f(x,y) de la forme suivante :

$$f(\xi) = \frac{1}{\pi(1+\eta)} \left( \frac{1}{\alpha^2} e^{\frac{-\xi^2}{\alpha^2}} + \frac{\eta}{\beta^2} e^{\frac{-\xi^2}{\beta^2}} \right)$$

Avec les notations suivantes :

- $\alpha$ est la largeur du rayonnement direct;
- $\beta$ est la largeur de rétrodiffusion ;
- $\eta$ est le ratio des intensités des rayonnements direct et rétrodiffusé.
- $\xi$ est la position radiale d'un point.

Les valeurs des paramètres $\alpha$, $\beta$ et $\eta$ peuvent être déterminées expérimentalement pour un procédé donné. Ces paramètres sont fonction de la tension d'accélération de la machine et de la cible. Typiquement pour une tension d'accélération de l'ordre de 50KV et une cible de silicium ou de verre ($SiO_2$) , $\alpha$ est de l'ordre de 30nm, $\beta$ de l'ordre de 10 $\mu$m et $\eta$ de l'ordre de 0.5. La performance de ce modèle n'est cependant pas bonne, notamment pour les effets lointains qui sont dominés par la rétrodiffusion. D'autres PSF permettent d'obtenir de meilleures performances, notamment celles du type suggéré par Kamikubo dans « Mask Process Correction (MPC) modeling and its application to EUV mask for Electron beam mask writer, EBM-7000 », Photomask Technology, Proc. of SPIE, Vol. 7823,782331, 2010 ou le modèle suggéré par Belic dans la demande de brevet publiée sous le n°US2008/067446 A1. Kamikubo suggère l'utilisation d'une PSF comprenant une fonction exponentielle et démontre une amélioration par rapport au modèle gaussien. Belic présente un modèle avec une combinaison linéaire de plusieurs gaussiennes, un ou plusieurs coefficients de la combinaison pouvant être négatifs pour donner à la PSF une forme fonctionnelle correspondant mieux à la réalité physique. On constate cependant que ces variantes de la forme fonctionnelle traditionnelle de PSF, dont les performances peuvent être évaluées à la fois expérimentalement et par comparaison avec un modèle de simulation de la diffusion des électrons par la méthode de Monte-Carlo (que l'on qualifiera dans la suite de la présente description de modèle de référence) apportent des améliorations qui restent insuffisantes à longue distance, notamment dans les applications du type gravure de masques en extrême UV (ultraviolet), lesdits masques comportant généralement des couches de métaux lourds tels que le tantale. Une des caractéristiques communes des PSF de l'art antérieur est d'utiliser des fonctions centrées, c'est-à-dire dont le maximum d'amplitude est localisé au lieu d'interaction du centre du faisceau électronique avec la cible (on dira par la suite pour simplifier au centre du faisceau); or ce modèle n'est pas bien ajusté à la réalité, notamment dans les scenarios d'application décrits ci-dessus dans lesquels la part de la rétrodiffusion est importante.

La présente invention résout le problème posé par les écarts de modélisation des effets de proximité en utilisant une classe de modèles dont la PSF n'a pas un pic au centre du faisceau.

A cet effet, l'invention prévoit un procédé de projection d'un faisceau électronique sur une cible selon la revendication indépendante 1, donc caractérisé en ce que ladite fonction d'étalement de point comprend au moins une fonction dont la valeur d'amplitude maximale n'est pas localiséeau centre du faisceau.

Avantageusement, ladite au moins une fonction dont la valeur d'amplitude maximale n'est pas localisée au centre du faisceau a sa valeur maximale centrée au pic de diffusion du faisceau électronique ver l'arrière.

Avantageusement, ladite au moins une fonction dont la valeur d'amplitude maximale n'est pas localisée au centre du faisceau est une fonction de distribution gamma.

Avantageusement, ladite fonction d'étalement de point comprend également une fonction dont la valeur maximale est localisée au centre du faisceau pour modéliser la diffusion vers l'avant.

Avantageusement, ladite fonction d'étalement de point comprend au moins autant de fonctions dont la valeur maximale n'est pas localisée au centre du faisceau que de pics de diffusion vers l'arrière, avec au moins une fonction dont la valeur maximale est localisée sur chaque pic.

Avantageusement, ladite fonction d'étalement de point est une combinaison linéaire d'au moins une gaussienne et d'au moins une fonction gamma.

Pour mettre en oeuvre le procédé, l'invention prévoit également un programme d'ordinateur selon la revendication indépendante 8. L'invention couvre également un système de lithographie électronique, un système de simulation d'au moins une étape de lithographie électronique, un système de microscopie électronique, chacun desdits systèmes comprenant un module de projection d'un faisceau électronique sur une cible et un programme d'ordinateur selon l'invention.

Dans un mode de réalisation de l'invention dans lequel on utilise une PSF comprenant deux fonctions de distribution gamma, on a pu démontrer une amélioration très importante de l'erreur quadratique résiduelle moyenne qui est inférieure de 49% à celle constatée avec deux gaussiennes centrées et de 32% à celle constatée avec l'amélioration apportée par Kamikubo.

En outre, les classes de fonction utilisées dans ce mode de réalisation ayant une expression analytique, elles peuvent facilement être intégrées dans les outils du commerce sans modification importante. La fonction de distribution cumulée étant elle-même analytique, les calculs de convolution qui sont nécessaires à la correction des effets de proximité restent du même ordre de complexité calculatoire que les solutions de l'art antérieur.

L'invention sera mieux comprise, ses différentes caractéristiques et avantages ressortiront de la description qui suit de plusieurs exemples de réalisation et de ses figures annexées dont :

- Les figures 1 a et 1b illustrent l'effet de rétrodiffusion des électrons ;
- Les figures 2a, 2b, 2c et 2d illustrent quatre modèles de l'énergie absorbée par la couche de résine d'une surface à graver par un procédé de lithographie électronique, respectivement selon un modèle de référence, selon un premier et un deuxième modèle de l'art antérieur et selon un mode de réalisation de l'invention;

- La figure 3 représente des fonctions de distribution gamma utilisées dans certains modes de réalisation de l'invention, avec différentes valeurs de paramètres ;
- Les figures 4a et 4b représentent la distribution du nombre d'électrons rétrodiffusés sur la surface de la cible dans le cas d'une gravure de masque avec un substrat en verre et respectivement un absorbeur Cr et Ta.

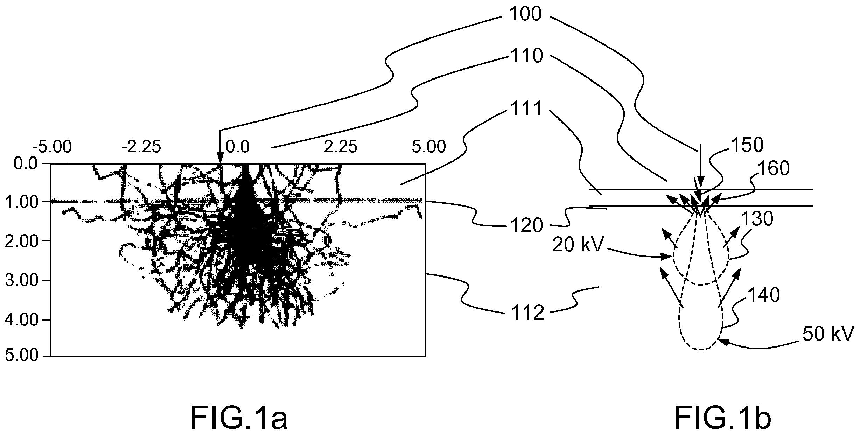

Les figures 1 a et 1b illustrent l'effet de rétrodiffusion des électrons.

Sur la figure 1a, on a représenté une coupe verticale des trajectoires des électrons du faisceau dans la cible 110 (couche de résine 111 puis dans le substrat 112 délimitée par la ligne 120). On observe le caractère aléatoire des trajectoires qui se prête bien à une modélisation par une simulation de Monte-Carlo. Cependant, une simulation de ce type est difficile à utiliser en production car elle ne permet pas d'effectuer de calcul direct avec des fonctions paramétrées ou tabulées.

Sur la figure 1b, on a modélisé les deux effets de diffusion résultant des interactions du faisceau électronique 100 avec la cible 110. Deux nuages de diffusion 130, 140 sont représentés qui correspondent à des tensions d'accélération de 20 kV et 50 kV. La diffusion vers l'avant est représentée par la flèche 150 et la rétrodiffusion par les flèches 160. On note que plus la tension d'accélération est élevée, plus le nuage est profond mais plus l'ouverture de ce nuage est faible. Les électrons rétrodiffusés seront éjectés au niveau de la surface de la cible à une distance plus grande du point d'impact du centre du faisceau si la tension est élevée.

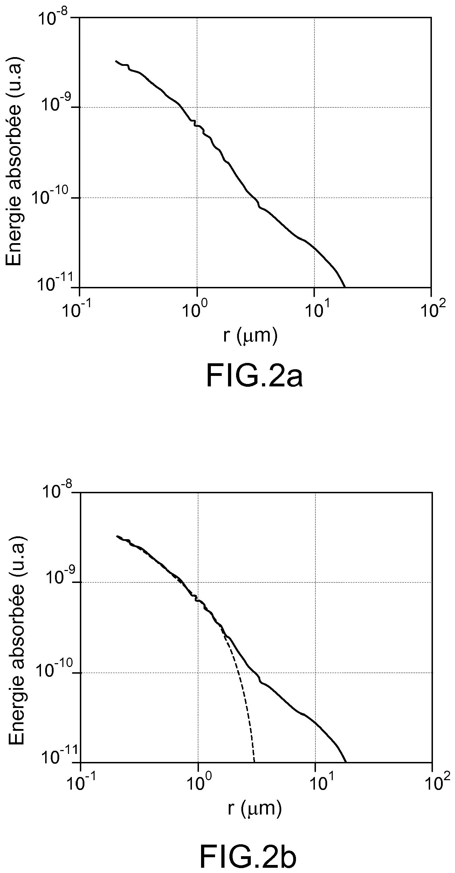

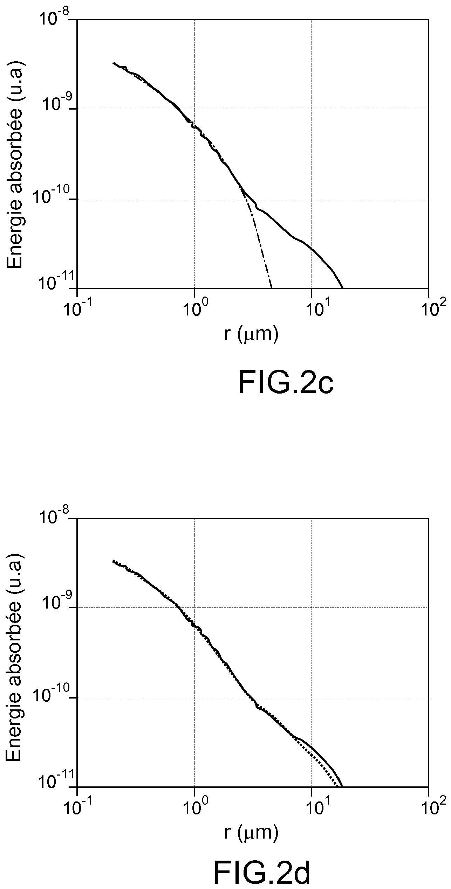

Les figures 2a, 2b, 2c et 2d illustrent quatre modèles de l'énergie absorbée par la couche de résine d'une surface à graver par un procédé de lithographie électronique, respectivement selon un modèle de référence, selon un premier et un deuxième modèle de l'art antérieur et selon un mode de réalisation de l'invention. Ces figures tiennent compte uniquement des phénomènes de rétrodiffusion (pas de la diffusion vers l'avant). Elles représentent donc la PSF de la rétrodiffusion.

Sur la figure 2a, figure une courbe qui retrace l'évolution de l'absorption de l'énergie du faisceau d'électron dans la couche de résine (dans une unité arbitraire d'énergie) en fonction de la distance au centre du faisceau (en microns), selon une simulation effectuée par une méthode de Monte-Carlo. Les conditions de l'expérience sont celles retracées par la publication de Kamikubo citée plus haut. Cette courbe constitue le modèle de référence des mesures pour apprécier la pertinence des différents modèles de PSF de la rétrodiffusion.

Sur la figure 2b, figure la courbe qui retrace la PSF de la rétrodiffusion modélisée par une somme de deux fonctions gaussiennes.

Les deux fonctions utilisées sont chacune centrée sur le centre du faisceau électronique. On observe une divergence significative de la courbe 2b avec la courbe du modèle de référence pour des distances au centre du faisceau supérieures à quelques microns (dans les conditions de l'expérience de Kamikubo).

Sur la figure 2c, figure la courbe qui retrace la PSF de la rétrodiffusion modélisée par la fonction décrite par Kamikubo dans la publication citée plus haut.

Kamikubo utilise des fonctions exponentielles pour modéliser la PSF dans les distances au centre du faisceau intermédiaires inférieures à 1 micron.. Ces fonctions présentent également un maximum au niveau du centre du faisceau. On voit sur la courbe 2b que le fit avec le modèle de référence est meilleur que dans le cas de la figure 2a, mais il subsiste un écart important pour des distances au centre du faisceau supérieures à environ 5 microns (dans les conditions de l'expérience de Kamikubo). Une amélioration est donc souhaitable. C'est ce que procure le procédé de l'invention.

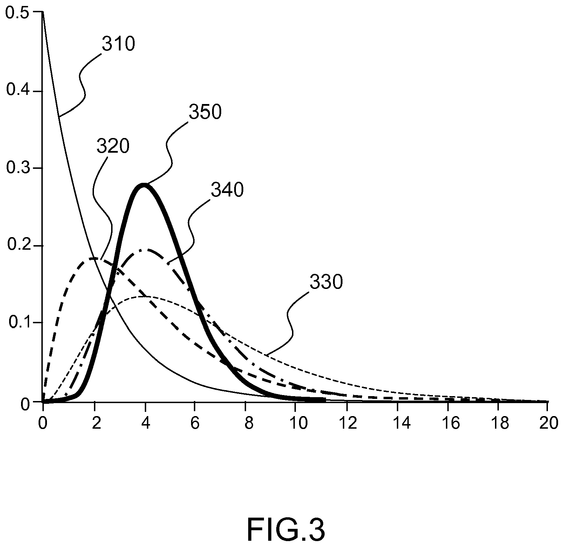

Sur la figure 2d, figure la courbe qui retrace la PSF de la rétrodiffusion modélisée selon le procédé de l'invention. Ce modèle sera décrit en détail en commentaires à la figure 3. On observe sur la courbe que le fit avec le modèle de référence est presque parfait, même à des distances importantes (dans les conditions de l'expérience de Kamikubo), de l'ordre de 10 microns par rapport au centre du faisceau électronique.

Le fit est mesuré par l'erreur quadratique résiduelle moyenne (mean square error). Comme indiqué plus haut, cet écart est meilleur de 49% par rapport au modèle de PSF de la figure 2b et de 32% par rapport au modèle de PSF de Kamikubo.

Pour atteindre ce résultat, la PSF de la rétrodiffusion est modélisée par une fonction (ou une combinaison de fonctions) dont la valeur maximale n'est pas centrée (c'est-à-dire dont le maximum n'est pas localisé au niveau du centre du faisceau mais décalé par rapport à celui-ci, sans que cela implique une quelconque asymétrie au niveau de la fonction comme dans le cas d'une gaussienne). Il s'agit simplement d'une fonction en cloche dont le maximum est décalé par rapport au centre du faisceau. Une telle fonction permet de mieux rendre compte du fait que les électrons rétrodiffusés sont « éjectés » hors de la cible à une certaine distance du centre du faisceau. Il est possible d'utiliser un nombre de fonctions plus petit lorsque leur maxima ne sont pas localisés au centre du faisceau en comparaison avec le nombre nécessaire pour des fonctions dont le maxima sont localisés au centre du faisceau. Il est néanmoins possible d'utiliser un plus grand nombre de fonctions selon l'invention pour améliorer ainsi davantage le fit. En fait, il est possible, selon l'invention, d'utiliser une seule fonction par pic observé sur la courbe, alors que, lorsque l'on utilise des fonctions gaussiennes dont les maxima sont localisés à chaque pic, il est nécessaire d'utiliser au moins deux fonctions par pic (avec des coefficients négatifs pour certaines d'entre elles), pour modéliser chaque pic. Cet exemple de l'art antérieur selon Belic augmente le temps de calcul nécessaire pour optimiser les paramètres. De plus, lorsque l'on utilise des fonctions dont les maxima ne sont pas localisés aux pics du faisceau, lesdites fonctions sont indépendantes l'une de l'autre du fait la part prépondérante de l'impact de chaque fonction s'applique à un seul point de la courbe. Ainsi les calculs d'optimisation sont plus simples.

La figure 3 représente des fonctions de distribution gamma utilisées dans certains modes de réalisation de l'invention, avec différentes valeurs de paramètres.

La fonction qui pourra avantageusement être utilisée pour modéliser la PSF de la rétrodiffusion est une fonction de distribution gamma de paramètres k et θ.

L'équation est de la forme :

$$f(\xi; k, \theta) = \xi^{k-1} \frac{e^{-\xi/\theta}}{\theta^k \Gamma(k)}$$

Expression dans laquelle Γ(k) est la valeur de la fonction gamma pour le paramètre k. La définition mathématique de la fonction gamma est donnée par l'expression suivante :

$$\Gamma(k) = \lim_{n \to \infty} \frac{n! \, n^k}{k(k+1)\ldots(k+n)}$$

Les valeurs des paramètres k et θ sont choisies pour optimiser le fit avec le modèle de référence (ces deux paramètres jouent sur la symétrie de la courbe, le placement de ce pic et l'amplitude de son maximum. Par exemple le pic de la distribution est situé à la position (k-1)θ. Toutes les méthodes d'optimisation sont possibles pourréaliser ce choix de paramètres ; on pourra citer notamment des méthodes d'optimisation locale par exemple celles basées sur l'algorithme de Levenberg-Marquardt ou l'algorithme du Simplexe ou des méthodes d'optimisation plus globale, par exemple le krigeage ou des méthodes basées sur des algorithmes génétiques.

Sur les courbes de la figure 3, sont représentées à titre d'exemples des fonctions gamma pour les valeurs suivantes des paramètres k et θ :

- k = 1 ; θ = 2 ; (courbe 310) ;

- k = 2 ; θ = 2 ; (courbe 320) ;

- k = 3 ; θ = 2 ; (courbe 330) ;

- k = 5 ; θ = 1 ; (courbe 340) ;

- k = 9 ; θ = 0,5 ; (courbe 350) ;

D'autres valeurs des paramètres k et θ sont évidemment possibles. Plusieurs fonctions de distribution gamma peuvent être combinées, par exemple linéairement pour trouver le fit le meilleur.

Selon l'invention, les fonctions de distribution gamma sont choisies de manière à ce que la valeur maximale de la distribution résultante soit décentrée par rapport au centre du faisceau électronique. De manière privilégiée, le centre de la distribution est ajusté au pic de diffusion vers l'arrière (rétrodiffusion ou backscattering). Ce choix est particulièrement avantageux lorsque l'effet de diffusion vers l'arrière est particulièrement important, notamment lorsque des couches de tantale ou de tantale dopé à l'azote sont implantées sur le substrat comme c'est le cas dans les applications à la fabrication de masques extrême UV. En effet, ces couches de matériaux lourds provoquent une diffusion vers l'arrière très significative.

Pour ces applications notamment, il est possible de réaliser l'invention en utilisant également des fonctions gaussiennes, ou améliorées par le procédé de Kamikubo, dans laquelle la valeur maximale de la distribution des effets de rétrodiffusion est centrée non pas sur le centre du faisceau électronique, mais est décentrée par rapport à celui-ci. Avantageusement, le centrage de la valeur maximale de la distribution est paramétré au pic de la diffusion vers l'arrière. On constate en effet à la fois expérimentalement et par simulation de Monte-Carlo que ledit pic est décentré par rapport au centre du faisceau électronique. Il peut y avoir plusieurs pics de diffusion. Dans ce cas, on choisira avantageusement de combiner autant de fonctions que de pics de diffusion, avec avantageusement au moins une fonction dont la valeur maximale est localisée sur chaque pic.

L'équation de la PSF est ainsi traditionnellement représentée par une fonction $f(\xi)$ ou f(x,y) de la forme suivante :

$$f(\xi) = \frac{1}{\pi(1+\sum \eta i)}\left( \frac{1}{\alpha^2} e^{\frac{-(r-mi)^2}{\alpha^2}} + \sum \frac{\eta i}{\beta^2} e^{\frac{-(r-mi)^2}{\beta^2}} \right)$$

Avec les notations suivantes :

- α est la largeur du rayonnement direct;
- β est la largeur de rétrodiffusion ;
- η est le ratio des intensités des rayonnements direct et rétrodiffusé.
- r est la position radiale d'un point.
- m est la moyenne du pic ; si m=0, la valeur maximale est localisée au centre du faisceau ; Si m>0, la valeur maximale est localisée à m.

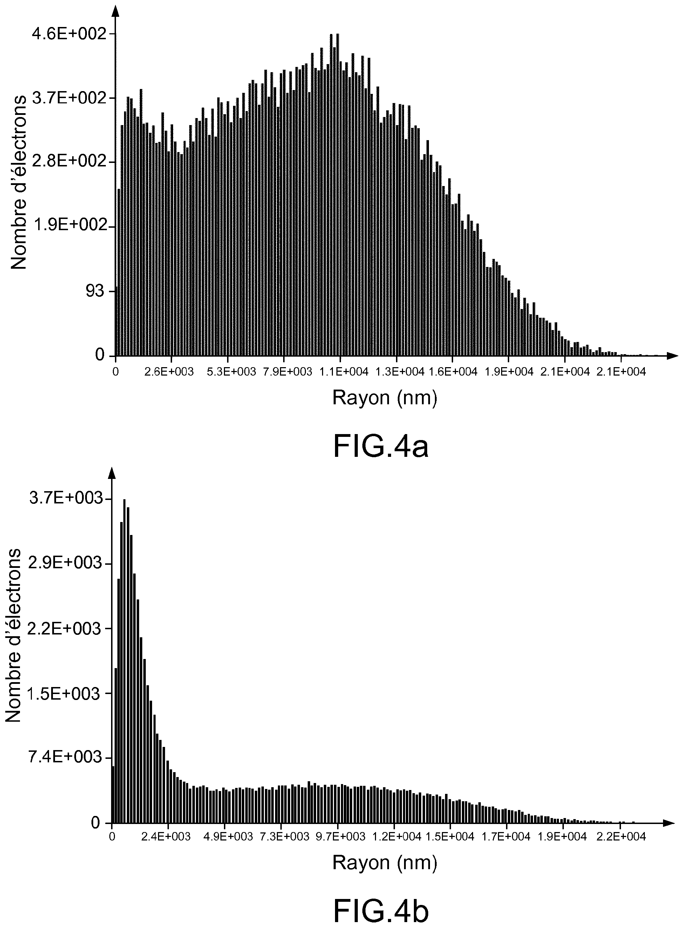

Les figures 4a et 4b représentent la distribution du nombre d'électrons rétrodiffusés sur la surface de la cible dans le cas d'une gravure de masque avec un substrat en verre et respectivement un absorbeur Cr et Ta..

Typiquement, pour la lithographie en UV, UV profond ou visible, les masques utilisées sont des masques en transmission. La figure 4a donne le nombre d'électrons rétrodiffusés à la surface dans le cas d'un masque standard chrome/verre. On observe un pic principal de rétrodiffusion autour de 10 microns, correspondant à la rétrodiffusion dans le verre. Il y a bien également un pic autour de un micron correspondant à la rétrodiffusion par l'absorbeur de Chrome mais ce pic est plus faible que le pic à 10 microns et peut être négligé. Ainsi une seule courbe gamma peut avantageusement suffire pour rendre compte de la rétrodiffusion, avec sa valeur maximale centrée sur le pic de rétrodiffusion du substrat, ici autour de 10 microns. Il est malgré tout possible d'utiliser plusieurs courbes en cloches (gaussienne, gamma...) dont l'une au moins sa valeur maximale localisée sur ce pic.

En lithographie extrême UV, les masques fonctionnent en réflexion, ils utilisent des absorbeurs avec des matériaux plus lourds que le chrome, par exemple Ta ou TaN. La courbe 4b donne le nombre d'électrons rétrodiffusés à la surface dans le cas d'un masque Ta/verre (avec le même nombre total d'électrons que pour le masque Cr/verre précédemment décrit en relation avec la figure 4a). On constate que la bosse due à la rétrodiffusion par l'absorbeur (avec son pic autour de $1\mu$m) est très grande comparée à celle due à la rétrodiffusion dans le substrat (pic autour de $10\mu$m). Avantageusement, dans ce cas, on utilisera pour modéliser la rétrodiffusion deux courbes gamma ayant leur valeurs maximales centrées chacune sur l'un de ces pics de rétrodiffusion (celui du substrat et celui de l'absorbeur). Il est malgré tout possible d'utiliser plusieurs courbes en cloches (gaussienne, gamma...) dont l'une au moins a sa valeur maximale sur le pic de rétrodiffusion dans le substrat et une autre a sa valeur maximale sur le pic de rétrodiffusion dans l'absorbeur.

Un exemple de fonction d'étalement pour la diffusion vers l'avant et vers l'arrière avec une combinaison de courbes gaussiennes et gamma est donné par l'expression suivante :

$$PSF(r) = \frac{1}{1 + \eta_1 + \eta_2}\left[\frac{1}{\pi\alpha^2}\exp\left({-r^2}/{\alpha^2}\right) + \frac{\eta_1}{\pi\beta^2}\exp\left({-r^2}/{\beta^2}\right) + \frac{\eta_2}{2\pi\kappa_1\theta_1}r^{\kappa_1-1}\frac{\exp\left({-r}/{\theta_1}\right)}{\Gamma(\kappa_1)\theta_1^{\kappa_1}}\right]$$

Pour mettre en oeuvre le procédé de l'invention dans ses applications à la lithographie électronique par projection directe sur wafers ou par gravure de masque, on peut utiliser par exemple une machine de type SB 3054 de la société VISTEC™. La modulation de dose peut par exemple être effectuée, selon l'invention, en modifiant un logiciel de modulation de dose, par exemple le logiciel de marque PROXECCO™ distribué par la société Synopsis™ ou le logiciel Inscale™ de la société Aselta Nanographics™ pour remplacer la PSF de la rétrodiffusion de l'art antérieur par la PSF de la rétrodiffusion décrite ci-dessus. Pour la PSF de diffusion vers l'avant, on pourra utiliser comme dans l'art antérieur une gaussienne centrée ou tout autre type de courbe en cloche ayant sa valeur maximale centrée sur le centre du faisceau.

La modulation de dose est effectuée par convolution de la PSF (PSF de la diffusion vers l'avant et PSF de la rétrodiffusion) avec la géométrie du motif à graver. Le logiciel peut également être avantageusement modifié pour réaliser une optimisation combinée de la modulation de dose et de la géométrie du motif à graver, selon un procédé tel que celui décrit dans la demande internationale PCT/EP2011/05583 appartenant à un des déposants de la présente demande.

Le procédé de l'invention et le programme d'ordinateur pour le mettre en oeuvre peuvent être également utilisés pour optimiser la PSF de systèmes de microscopie électronique qui peuvent être utilisés en imagerie ou pour réaliser l'inspection de wafers ou de masques. Ils peuvent également être adaptés pour réaliser une simulation d'une ou plusieurs étapes d'un procédé de lithographie électronique.

Les exemples décrits ci-dessus sont donc donnés à titre d'illustration certains de modes de réalisation de l'invention. Ils ne limitent en aucune manière le champ de l'invention qui est défini par les revendications qui suivent.

**Revendications**

1. Procédé de projection d'un faisceau électronique (100) sur une cible (110) comprenant une étape de correction des effets de diffusion dudit faisceau vers l'avant (150) et vers l'arrière (160) résultant des interactions du faisceau électronique avec la cible, ladite étape comprenant une sous-étape de calcul d'une fonction d'étalement de point pour ladite diffusion, ledit procédé étant **caractérisé en ce que** ladite fonction d'étalement de point comprend au moins une fonction dont la valeur d'amplitude maximale n'est pas localisée au centre du faisceau.

2. Procédé de projection selon la revendication 1, **caractérisé en ce que** ladite au moins une fonction dont la valeur d'amplitude maximale n'est pas localisée au centre du faisceau a sa valeur maximale localisée au pic de diffusion du faisceau électronique vers l'arrière.

3. Procédé de projection selon l'une des revendications 1 à 2, **caractérisé en ce que** ladite au moins une fonction dont la valeur d'amplitude maximale n'est pas localisée au centre du faisceau est une fonction en cloche dont le maximum est décalé par rapport au centre du faisceau.

4. Procédé de projection selon l'une des revendications 1 à 3, **caractérisé en ce que** ladite au moins une fonction dont la valeur d'amplitude maximale n'est pas localisée au centre du faisceau est une fonction de distribution gamma.

5. Procédé de projection selon l'une des revendications 1 à 4, **caractérisé en ce que** ladite fonction d'étalement de point comprend également une fonction dont la valeur maximale est localisée au centre du faisceau pour modéliser la diffusion vers l'avant.

6.  Procédé de projection selon l'une des revendications 1 à 5, **caractérisé en ce que** ladite fonction d'étalement de point comprend au moins autant de fonctions dont les valeurs maximales ne sont pas localisées au centre du faisceau que de pics de diffusion vers l'arrière, avec au moins une fonction dont la valeur maximale est localisée sur chaque pic.

7.  Procédé de projection selon l'une des revendications 1 à 6, **caractérisé en ce que** ladite fonction d'étalement de point est une combinaison linéaire d'au moins une gaussienne et d'au moins une fonction gamma.

8.  Programme d'ordinateur comprenant des instructions de code de programme permettant l'exécution du procédé de projection d'un faisceau électronique selon l'une des revendications 1 à 7 lorsque le programme est exécuté sur un ordinateur, ledit programme comprenant un module de simulation et/ou correction desdits effets de diffusion dudit faisceau vers l'avant (150) et vers l'arrière (160), ledit module comprenant un sous-module de calcul dudite fonction d'étalement de point, ledit programme étant **caractérisé en ce que** ladite fonction d'étalement de point comprend au moins ladite fonction dont la valeur d'amplitude maximale n'est localisée au centre du faisceau..

9.  Programme d'ordinateur selon la revendication 8, **caractérisé en ce que** ladite fonction d'étalement de point comprend au moins une fonction dont la valeur maximale est localisée au pic de diffusion du faisceau électronique vers l'arrière.

10. Programme d'ordinateur selon l'une des revendications 8 ou 9, **caractérisé en ce que** ladite fonction d'étalement de point comprend au moins une gaussienne et au moins une fonction gamma non centrée

11. Système de lithographie électronique comprenant un module de projection d'un faisceau électronique sur une cible et un programme d'ordinateur selon une des revendications 8 à 10.

12. Système de simulation d'au moins une étape de lithographie électronique comprenant un module de simulation d'une étape de projection d'un faisceau électronique sur une cible et un programme d'ordinateur selon une des revendications 8 à 10.

13. Système de microscopie électronique comprenant un module de projection d'un faisceau électronique sur une cible et un programme d'ordinateur selon une des revendications 8 à 10.

**Patentansprüche**

1.  Verfahren zum Projektieren eines Elektronenstrahls (100) auf ein Target (110), das einen Korrekturschritt der Streuwirkungen des vorwärts gerichteten (150) und rückwärts gerichteten (160) Strahls umfasst, die sich aus Wechselwirkungen des Elektronenstrahls mit dem Target ergeben, wobei der Schritt einen Berechnungsteilschritt einer Punktstreufunktion für die Streuung umfasst, wobei das Verfahren **dadurch gekennzeichnet** wird, dass die Punktstreufunktion mindestens eine Funktion umfasst, wobei der Wert der Maximalamplitude nicht im Strahlzentrum lokalisiert wird.

2.  Verfahren zum Projektieren nach Anspruch 1, **dadurch gekennzeichnet, dass** die mindestens eine Funktion, deren Wert der Maximalamplitude nicht im Strahlzentrum lokalisiert wird, ihren Maximalwert im Scheitelpunkt der rückwärts gerichteten Streuung des Elektronenstrahls lokalisiert hat.

3.  Verfahren zum Projektieren nach einem der Ansprüche 1 bis 2, **dadurch gekennzeichnet, dass** die mindestens eine Funktion, deren Wert der Maximalamplitude nicht im Strahlzentrum lokalisiert wird, eine Glockenfunktion ist, deren Maximum gegenüber dem Strahlzentrum verschoben ist.

4.  Verfahren zum Projektieren nach einem der Ansprüche 1 bis 3, **dadurch gekennzeichnet, dass** die mindestens eine Funktion, deren Wert der Maximalamplitude nicht im Strahlzentrum lokalisiert wird, eine Funktion mit Gammaverteilung ist.

5.  Verfahren zum Projektieren nach einem der Ansprüche 1 bis 4, **dadurch gekennzeichnet, dass** die Punktstreufunktion gleichermaßen eine Funktion umfasst, deren Maximalwert im Strahlzentrum lokalisiert wird, um die vorwärts gerichtete Streuung zu modellieren.

6. Verfahren zum Projektieren nach einem der Ansprüche 1 bis 5, **dadurch gekennzeichnet, dass** die Punktstreufunktion mindestens so viele Funktionen umfasst, deren Maximalwerte nicht im Strahlzentrum lokalisiert werden, wie Scheitelpunkte der rückwärts gerichteten Streuung, mit mindestens einer Funktion, deren Maximalwert auf jedem Scheitelpunkt lokalisiert wird.

7. Verfahren zum Projektieren nach einem der Ansprüche 1 bis 6, **dadurch gekennzeichnet, dass** die Punktstreufunktion eine Linearkombination von mindestens einer Gaußschen- und von mindestens einer Gamma-Funktion ist.

8. Computerprogramm, das Programmcodebefehle umfasst, die die Ausführung des Verfahren zum Projektieren eines Elektronenstrahls nach einem der Ansprüche 1 bis 7 erlauben, wenn das Programm auf einem Computer ausgeführt wird, wobei das Programm ein Simulationsmodul und/oder Korrektur der Streuwirkungen des vorwärts gerichteten (150) und rückwärts gerichteten (160) Strahls umfasst, wobei das Modul ein Teilmodul der Berechnung der Punktstreufunktion umfasst, wobei das Programm **dadurch gekennzeichnet** wird, dass die Punktstreufunktion mindestens die Funktion umfasst, deren Wert der Maximalamplitude nicht im Strahlzentrum lokalisiert wird.

9. Computerprogramm nach Anspruch 8, **dadurch gekennzeichnet, dass** die Punktstreufunktion mindestens eine Funktion umfasst, deren Maximalwert im Scheitelpunkt der rückwärts gerichteten Streuung des Elektronenstrahls lokalisiert wird.

10. Computerprogramm nach einem der Ansprüche 8 oder 9, **dadurch gekennzeichnet, dass** die Punktstreufunktion mindestens eine Gaußsche- und mindestens eine nichtzentrierte Gamma-Funktion umfasst.

11. System für Elektronenstrahllithographie, das ein Projektionsmodul eines Elektronenstrahls auf ein Target und ein Computerprogramm nach einem der Ansprüche 8 bis 10 umfasst.

12. System für Simulation von mindestens einem Schritt von Elektronenstrahllithographie, das ein Simulationsmodul eines Projektionsschritts eines Elektronenstrahls auf ein Target und ein Computerprogramm nach einem der Ansprüche 8 bis 10 umfasst.

13. System für Elektronenstrahlmikroskopie, das ein Projektionsmodul eines Elektronenstrahls auf ein Target und ein Computerprogramm nach einem der Ansprüche 8 bis 10 umfasst.

**Claims**

1. A method for projecting an electronic beam (100) onto a target (110) comprising a step of correcting the effects of scattering said beam forward (150) and backward (160) resulting from the interactions of the electronic beam with the target, said step comprising a sub-step of computing a point spread function for said scattering, said method being **characterised in that** said point spread function comprises at least one function, the maximum amplitude value of which is not located at the centre of the beam.

2. The projection method according to claim 1, **characterised in that** the maximum value of said at least one function for which the maximum amplitude value is not located at the centre of the beam is located on the backward scattering peak of the electronic beam.

3. The projection method according to any one of claims 1 to 2, **characterised in that** said at least one function for which the maximum amplitude value is not located at the centre of the beam is a bell function, the maximum of which is offset relative to the centre of the beam.

4. The projection method according to any one of claims 1 to 3, **characterised in that** said at least one function for which the maximum amplitude value is not located at the centre of the beam is a gamma distribution function.

5. The projection method according to any one of claims 1 to 4, **characterised in that** said point spread function further comprises a function for which the maximum value is located at the centre of the beam for modelling the forward scattering.

6. The projection method according to any one of claims 1 to 5, **characterised in that** said point spread function comprises at least as many functions for which the maximum values are not located at the centre of the beam as there are backward scattering peaks, with at least one function for which the maximum value is located on each peak.

7. The projection method according to any one of claims 1 to 6, **characterised in that** said point spread function is a linear combination of at least one Gaussian function and at least one gamma function.

8. A computer program comprising program code instructions allowing the method for projecting an electronic beam according to any one of claims 1 to 7 to be executed when the program is executed on a computer, said program comprising a module for simulating and/or correcting said effects of scattering said beam forward (150) and backward (160), said module comprising a sub-module for computing said point spread function, said program being **characterised in that** said point spread function comprises at least said function for which the maximum amplitude value is not located at the centre of the beam.

9. The computer program according to claim 8, **characterised in that** said point spread function comprises at least one function for which the maximum value is located at the backward scattering peak of the electronic beam.

10. The computer program according to any one of claims 8 to 9, **characterised in that** said point spread function comprises at least one Gaussian function and at least one off-centred gamma function.

11. An electronic lithography system comprising a module for projecting an electronic beam onto a target and a computer program according to any one of claims 8 to 10.

12. A system for simulating at least one electronic lithography step comprising a module for simulating a step of projecting an electronic beam onto a target and a computer program according to any one of claims 8 to 10.

13. An electronic microscopy system comprising a module for projecting an electronic beam onto a target and a computer program according to any one of claims 8 to 10.

**FIG.1a**

**FIG.1b**

EP 2 560 187 B1

FIG.2a

FIG.2b

FIG.2c

FIG.2d

FIG.3

FIG.4a

FIG.4b

## RÉFÉRENCES CITÉES DANS LA DESCRIPTION

**Documents brevets cités dans la description**

- US 2008067446 A1

- EP 201105583 W

**Littérature non-brevet citée dans la description**

- **KAMIKUBO.** Mask Process Correction (MPC) modeling and its application to EUV mask for Electron beam mask writer, EBM-7000. *Photomask Technology, Proc. of SPIE,* 2010, vol. 7823, 782331